# EUROPÄISCHE PATENTANMELDUNG

(11) **EP 0 989 792 A2**
(43) Veröffentlichungstag der Anmeldung: **29.03.2000**
(21) Anmeldenummer: 99118556.2
(22) Anmeldetag: 20.09.1999
(51) Int. Cl.: H05K 3/36, H05K 1/02

(54) **Kunststoffolie für die Verklebung mit anderen Folien und Leiterplatten**

(30) Priorität: 25.09.1998 DE 19844098
(71) Anmelder: SIEMENS AKTIENGESELLSCHAFT, 80333 München (DE)
(72) Erfinder: Bogert, Josef, 46395 Bocholt (DE); Busch, Georg, 48683 Ahaus (DE)

(57) **Zusammenfassung**

Eine Kunststoffolie für die Verklebung mit anderen Folien oder Leiterplatten (1) unter Vermittlung eines Heißklebers, bei welcher zumindest in den Verklebungsbereichen wärmeleitende Brücken (19, 22) ausgebildet sind. Diese Brücken (19, 22) können z.B. als mit wärmeleitender Paste gefüllte Bohrungen (17) ausgebildet sein.

## Beschreibung

Die Erfindung bezieht sich auf eine Kunststoffolie für die Verklebung mit anderen Folien oder Leiterplatten unter Vermittlung eines Heißklebers.

Bei der Herstellung elektronischer Geräte, insbesondere bei der Produktion von Flachbaugruppen, ergibt sich immer wieder die Notwendigkeit, Folien durch Wärme mit einer anderen Folie oder mit einer Leiterplatte zu verkleben, wobei die Folie aus Kunststoff besteht und Leiterbahnen auf einer oder auf beiden Seiten aufweisen kann, elektronische Bauteile oder Schalter, z.B. sogenannte Polydome oder deren Teile enthält.

Zum Zwecke des Verklebens wird ein Heißkleber oder Heißsiegelklebstoff verwendet, der zwischen die Kunststoffolie und z.B. die Leiterplatte als Schichte gebracht wird, wobei dann mit Hilfe eines beheizten Stempels auf die Außenseite der Folie bei Hitzeeinwirkung Druck aufgebracht wird, wodurch der Heißkleber zusammengepreßt wird, und nach dem Abkühlen die Form beibehält. Soll nicht nur eine Verklebung, sondern auch noch eine elektrische Kontaktierung an der Klebestelle erfolgen, so sind in den Heißkleber Metallkügelchen, z.B. Goldkügelchen verteilt enthalten, die beim Zusammenpressen mit den leitfähigen Seiten der zu verklebenden Folien in Kontakt kommen und dann als elektrisch leitende Brücken verbleiben. Es sind verschiedene Technologien des Heißpressens bekannt, beispielsweise das sogenanntes Bügellöten, bei dem ein Metallbügel elektrisch erhitzt und gegen die zu verschweißenden Materialien gepreßt wird. Die thermischen Preßstempel werden oft auch als 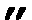 Thermode" bezeichnet, in Analogie zu 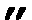 Elektroden".

Ein Problem bei dem heiß-Verkleben liegt darin, daß die verwendeten Kunststoffolien, die z.B. aus Polyester bestehen, eine geringe Wärmeleitfähigkeit haben, und daher - auch wenn sie dünn sind - eine hohe Temperatur des Preßstempels erfordern. Zu hohe Temperaturen bringen aber eine Verunreinigung der Preßstempel mit sich, da die Folien zum Teil anschmelzen, wobei man als Abhilfe oft zusätzliche Materialien, z.B. Bänder aus Polytetrafluorethylen als Schutz der Thermoden in den Wärmefluß schaltet. Solche Maßnahmen erhöhen wiederum die Zykluszeiten, und eine hohe Produktionskapazität läßt sich nur durch viele parallel laufende Verklebungsprozesse erreichen.

Es ist eine Aufgabe der Erfindung, die besprochenen thermischen Probleme zu vermindern, um eine kürzere Prozeßzeit und damit eine höhere Produktionskapazität bei gleichem Maschinenaufwand zu ermöglichen. Diese Aufgabe wird, ausgehend von einer Kunststoffolie der eingangs genannten Art dadurch erreicht, daß in der Folie zumindest in den Verklebungsbereichen wärmeleitende Brücken ausgebildet sind.

Durch diese Maßnahme wird der Wärmewiderstand des Folienmaterials an bestimmten Kontaktierungsstellen wesentlich herabgesetzt, so daß die Wärme des Preßstempels bzw. der Thermode rasch über die wärmeleitenden Brücken zu dem Heißkleber übertragen werden kann, somit unmittelbar in den tatsächlich interessierenden Bereich. Dadurch lassen sich die Zykluszeiten für eine gute Verbindungsqualität drastisch reduzieren.

Bei einer in der Praxis vorteilhaften Ausführungsform sind die Brücken als Bohrungen ausgebildet, die mit wärmeleitender Paste gefüllt sind. Insbesondere können die Bohrungen mit eine Silberleitpaste gefüllt sein.

Man kann zu preisgünstigen Lösungen gelangen, wenn die wärmeleitenden Brücken durch die Wärmeeinwirkung während des Verklebens zerstörbar sind, d.h. es müssen keine dauerhaft hitzebeständigen Brücken verwendet werden, welche die Kosten erhöhen würden.

Zweckmäßigerweise können die wärmeleitenden Brücken auch als die Folie durchsetzende Metallstifte ausgebildet sein, wobei man das Metall entsprechend der jeweiligen Anwendung wählt, beispielsweise im Hinblick auf Wärmeleitfähigkeit und Härte des Metalls.

Eine zweckmäßige Ausführungsform besteht auch darin, daß die wärmeleitenden Brücken als galvanische Durchkontaktierungen ausgebildet sind, zumal die Ausbildung derartiger Durchkontaktierungen für den Fachmann auf dem Gebiet von Leiterplatten problemlos durchführbar ist, da analoge elektrische Durchkontaktierungen oft ausgeführt werden.

Insbesondere bei Verwendung kreisförmiger Stempel ist es zweckmäßig, wenn die wärmeleitenden Brücken ringartig gruppiert sind, doch wird man bei größeren Flächen eine rasterartige Anordnung der Brücken vornehmen.

Die Kunststoffolie gemäß der Erfindung besteht bei bevorzugten Ausführungsformen aus Polyester oder aus einem thermostabilen Polyimid, wie es z.B. unter dem Markennamen 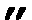 Kapton" im Handel erhältlich ist.

Die Folie nach der Erfindung kann auch an einer oder an beiden Seiten Leiterbahnen aufweisen, oder sie kann zusätzlich zu den wärmeleitenden Brücken elektrische Durchkontaktierungen enthalten, wobei kein prinzipieller Unterschied zwischen den elektrischen Durchkontaktierungen und den wärmeleitenden Brücken vorhanden sein muß.

Die Folie nach der Erfindung kann auch elektrische und/oder elektronische Bauteile enthalten und ebenso Schaltkontakte oder deren Teile aufweisen. Ein Beispiel für die Anwendung der Erfindung ist eine Kunststoffolie mit Schaltkontakten, wie sie für Tastaturen verwendet wird.

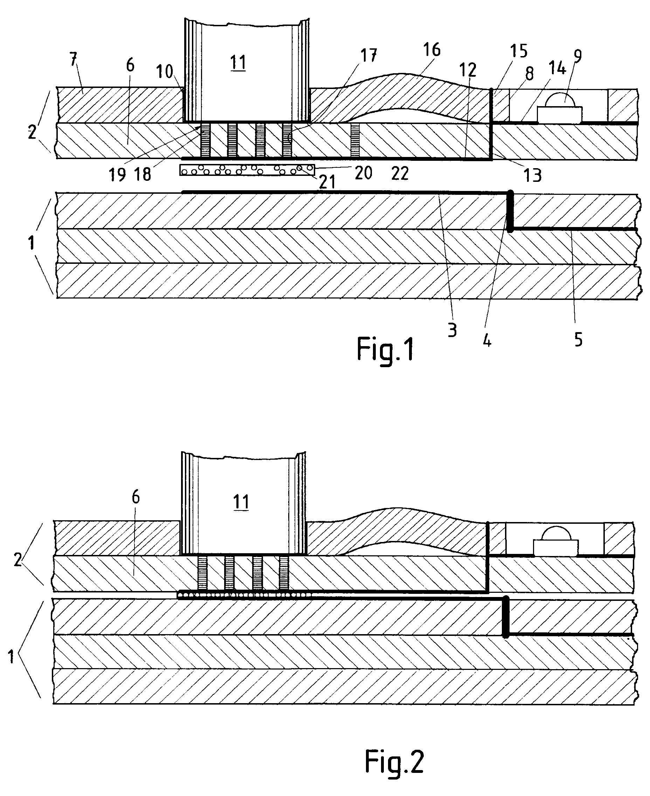

Die Erfindung samt weiterer Vorteile ist im folgenden anhand eines Ausführungsbeispiels näher erläutert, das in der Zeichnung veranschaulicht ist. In dieser zeigen
■ Fig. 1 einen Schnitt durch eine mit einer anderen Folie verbundenen Folie nach der Erfindung vor dem Verbinden mit einer vierlagigen Leiterplatte und
■ Fig. 2 in einer ebensolchen Darstellung diese Anordnung nach dem Heißverschmelzen.

In Fig. 1 erkennt man eine dreischichtige Leiterplatte 1, die mit einem Folienaufbau 2 lokal verbunden werden soll.

Auf der Leiterplatte 1 erkennt man eine Leiterbahn 3 an der oberen Fläche einer Schichte, die über eine Durchkontaktierung 4 mit einer Leiterbahn 5 auf der anderen Seite dieser Schichte in bekannter Weise in Verbindung steht.

Der Folienaufbau 2 besteht aus einer Kunststoffolie 6 und einer mit dieser verbundenen weiteren Deckfolie 7, wobei in der Deckfolie 7 eine erste Durchbrechung 8 eine LED 9 der Kunststoffolie 6 freistellt und eine zweite Durchbrechung 10, die im vorliegenden Fall kreisförmig ist, eine Freistellung für einen beheizten Stempel 11 realisiert.

Die Kunststoffolie 6 besitzt an ihrer Unterseite eine Leiterbahn 12, die beispielsweise über eine Durchkontaktierung 13 mit einer Leiterbahn 14 und einer weiteren Durchkontaktierung 15 der Deckfolie in Verbindung steht. Die Leiterbahn 15 kann dabei den Teil eines Schaltkontaktes im Zusammenhang mit der Erhebung 16 bilden. Folien 7 mit solchen Erhebungen 16 werden oft Polydome genannt und dienen als oberer Teil einer Eingabeeinrichtung bzw. Tastatur.

Wie man weiters der Zeichnung entnehmen kann, sind in der Kunststoffolie 6, die beispielsweise aus Polyester oder einem thermostabilen Polyimid sein kann, Bohrungen 17 ausgebildet und mit einem wärmeleitenden Stoffe, beispielsweise mit einer Silber-Leitpaste 18 gefüllt, wodurch wärmeleitende Brücken 19 gebildet werden. An dieser Stelle soll angemerkt werden, daß die Größenverhältnisse in der Zeichnung nicht mit der Realität übereinstimmen bzw. übereinstimmen müssen, sondern zum Zwecke der klaren Darstellung gewählt sind.

Zur Verbindung des Folienaufbaues 2, genauer gesagt der Kunststoffolie 6 mit der Oberfläche der Leiterplatte 1 wird eine Schicht 20 eines Heißklebers in den Bereich der zu verbindenden Stellen gebracht. Die Technik des Heißverklebens ist bekannt, und als Heißkleber werden beispielsweise (Co-) Polymere auf der Basis von Ethylen, Acrylaten, Vinylchlorid, Vinylidenchlorid und Vinylacetat sowie Polyamide, Polyester und Polyurethane verwendet.

Bei der beschriebenen Ausführungsform enthält die Schicht 20 des Heißklebers noch zusätzlich leitende Kügelchen 21, z.B. Goldkügelchen. Zum eigentlichen Verkleben wird nun der beheizte Stempel 11, der bei diesem Beispiel einen zylindrischen Endbereich besitzt, durch die Durchbrechung 10 auf die Kunststoffolie 6 gebracht, und sodann preßt der Stempel die Folie 6 mitsamt der Heißklebeschicht 19 gegen die Oberfläche der Leiterplatte 1. Die Silberleitpaste 18 in den Bohrungen 17 bildet wärmeleitende Brücken, welche die Wärme des beheizten Stempels 11 ohne große Verzögerung auf die Heißklebeschicht 20 bringen, so daß diese schmilzt, wobei durch das Schmelzen und den Druck letztlich die in Fig. 2 dargestellte Situation eintritt, in welcher zwischen den Leiterbahnen 12 bzw. 3 praktisch nur noch die Goldkügelchen 21 als elektrisch leitende Brücken verbleiben. Der Folienaufbau 2 ist dadurch mit der Leiterplatte 1 in dem gezeigten Bereich nicht nur verklebt, sondern auch leitend verbunden, wiewohl Gegenstand der Erfindung ganz allgemein das Verkleben ist, und die leitende Verbindung nicht oder nicht an allen Verklebungsstellen von Folien vorgesehen werden muß.

Bei dem vorliegenden Ausführungsbeispiel, bei welchem der Durchmesser des beheizten Stempels und der zu verklebenden Fläche im Bereich von mm liegt, können die wärmeleitenden Brücken 19 beispielsweise ringförmig angeordnet sein, doch wählt man die Konfiguration der Brücken 19 entsprechend der jeweils zu verklebenden Folien bzw. Leiterplatten, wobei man im allgemeinen eine gleichmäßige Verteilung der wärmeleitenden Brücken bevorzugen wird. Die wärmeleitenden Brücken müssen nicht notwendigerweise im unmittelbaren Verklebungsbereich vorgesehen sein, sie können vielmehr zusätzlich oder ausschließlich im Umfeld der Verklebung angeordnet sein, was an einer Brücke 22 in Fig. 1 ersichtlich ist.

Die wärmeleitenden Brücken 19, hier die Füllungen aus Silberleitpaste 18, können ohne weiteres durch die Wärme des beheizten Stempels 11 zerstörbar sein, da ihnen nach dem Verkleben keine Funktion mehr zukommt. Andererseits ist es jedoch möglich, anstelle einer wärmeleitenden Paste 18 in Bohrungen eingesetzte Metallstifte zu verwenden, oder die wärmeleitenden Brücken 19 können auch als galvanische Durchkontaktierungen ausgebildet sein.

Da die Erfindung eine sehr rasche Einbringung der notwendigen Wärme in den Bereich des Heißklebers ermöglicht, ergeben sich sehr kurze Zykluszeiten bei der Herstellung von Folienaufbauten. Wegen der kurzen Einwirkungszeit des beheizten Stempels auf die Folienoberfläche erübrigen sich Schutzmaßnahmen nach dem Stand der Technik, z.B. das Auflegen von Schutzfolien aus Polytetrafluorethylen zwischen die Stempeloberfläche und die Oberfläche der Kunststoffolie 6.

## Patentansprüche

1. Kunststoffolie (6) für die Verklebung mit anderen Folien oder Leiterplatten (1) unter Vermittlung eines Heißklebers, **dadurch gekennzeichnet,**
daß in der Folie (6) zumindest in den Verklebungsbereichen oder in deren Umfeld wärmeleitende Brücken (22) ausgebildet sind.

2. Folie (6) nach Anspruch 1,
**dadurch gekennzeichnet,** daß die Brücken (19, 22) als mit wärmeleitender Paste gefüllte Bohrungen (17) ausgebildet sind.

3. Folie (6) nach Anspruch 2,
**dadurch gekennzeichnet,** daß die Bohrungen (17) mit Silberleitpaste gefüllt sind.

4. Folie (6) nach einem der Ansprüche 1 bis 3,
**dadurch gekennzeichnet,** daß die wärmeleitenden Brücken (19, 22) durch die Wärmeeinwirkung während des Verklebens zerstörbar sind.

5. Folie (6) nach einem der Ansprüche 1 bis 3,
**dadurch gekennzeichnet,** daß die wärmeleitenden Brücken (19, 22) als die Folie (6) durchsetzende Metallstifte ausgebildet sind.

6. Folie (6) nach einem der Ansprüche 1 bis 3,
**dadurch gekennzeichnet,** daß die wärmeleitenden Brücken (19, 22) als galvanische Durchkontaktierungen ausgebildet sind.

7. Folie (6) nach einem der Ansprüche 1 bis 6,
**dadurch gekennzeichnet,** daß die wärmeleitenden Brücken (19, 22) ringartig gruppiert sind.

8. Folie (6) nach einem der Ansprüche 1 bis 7,
**dadurch gekennzeichnet,** daß sie aus Polyester oder einem thermostabilen Polyimid besteht.

9. Folie (6) nach einem der Ansprüche 1 bis 8,
**dadurch gekennzeichnet,** daß sie an einer oder an beiden Seiten Leiterbahnen (12, 14) aufweist.

10. Folie (6) nach einem der Ansprüche 1 bis 9,
**dadurch gekennzeichnet,** daß sie zusätzlich zu den wärmeleitenden Brücken (19, 22) elektrische Durchkontaktierungen (13) enthält.

11. Folie (6) nach einem der Ansprüche 9 oder 10,
**dadurch gekennzeichnet,** daß sie elektrische und/oder elektronische Bauteile (9) aufweist.

12. Folie (6) nach Anspruch 11,
**dadurch gekennzeichnet,** daß sie Schaltkontakte oder deren Teile aufweist.
